Europäisches Patentamt

(19) European Patent Office

Office européen des brevets

(11) Publication number : **0 227 839 B1**

(12) # EUROPEAN PATENT SPECIFICATION

(45) Date of publication of patent specification :
15.05.91 Bulletin 91/20

(51) Int. Cl.⁵ : **H01L 21/314, H01L 21/31, H01L 21/318**

(21) Application number : 86904352.1

(22) Date of filing : 27.06.86

(86) International application number :
PCT/JP86/00328

(87) International publication number :
WO 87/00346 15.01.87 Gazette 87/01

(54) METHOD OF FORMING A THIN FILM.

(30) Priority : 02.07.85 JP 144896/85
02.07.85 JP 144897/85
02.07.85 JP 144900/85

(43) Date of publication of application :
08.07.87 Bulletin 87/28

(45) Publication of the grant of the patent :
15.05.91 Bulletin 91/20

(84) Designated Contracting States :
DE FR GB

(56) References cited :
EP-A- 0 104 658
JP-A- 5 961 124
JP-A-57 199 225
JP-A-57 670 09
JP-A-59 124 124
JAPANESE JOURNAL OF APPLIED PHYSICS, SUPPLEMENTS, 16TH INT. CONF. SOLID STATE DEVICES AND MATERIALS, 30th August - 1st September 1984, pages 433-436, Tokyo, JP; T. SUGII et al.: "Low temperature nitridation of silicon by excimer laser irradiation"
JAPANESE JOURNAL OF APPLIED PHYSICS, vol. 23, no. 9, part 1, September 1984, pages 1209-1215, Tokyo, JP; K. HAMANO et al.: "Structural and electrical properties of photo-CVD silicon nitride film"
IBM TECHNICAL DISCLOSURE BULLETIN, vol. 27, no. 7B, December 1984, page 4435, New York, US; F.C. BURNS et al.: "Removal of the metal oxide layer from a metal by laser-assisted hydrogen reduction"
PATENT ABSTRACTS OF JAPAN, vol. 8, no. 247 (E-278)[1684], 13th November 1984 & JP-A-59-124 124

(56) References cited :
PATENT ABSTRACTS OF JAPAN, vol. 6, no. 143 (C-117)[1021], 3rd August 1982 & JP-A-57-67 009
PATENT ABSTRACTS OF JAPAN, vol. 8, no. 161 (E-257)[1598], 26th July 1984 & JP-A-59-61 124

(73) Proprietor : SEMICONDUCTOR ENERGY LABORATORY CO., LTD.
398 Hase
Atsugi-shi Kanagawa-ken, 243 (JP)

(72) Inventor : YAMAZAKI, Shunpei
7-21-21, Kitakarasuyama
Setagaya-ku Tokyo 157 (JP)
Inventor : URATA, Kazuo
Terrace Hase 13-10 381-1, Hase
Atsugi-shi Kanagawa-ken 243 (JP)
Inventor : TASHIRO, Mamoru
Pearl House 201 3-25-20, Soshigaya
Setagaya-ku Tokyo 157 (JP)
Inventor : TANAMURA, Yuji
1-13-18, Naruse
Machida-shi Tokyo 194 (JP)
Inventor : IMATO, Shinji
Flat Atsugi 303 931-1, Hase
Atsugi-shi Kanagawa-ken 243 (JP)

(74) Representative : Milhench, Howard Leslie et al
R.G.C. Jenkins & Co. 26 Caxton Street
London SW1H 0RJ (GB)

## Description

## BACKGROUND OF THE INVENTION

Field of the Invention

The present invention relates to a method of forming thin films such as gate insulating films, passivation films and reflection checking films on the surfaces of III-V group compound semiconductors by chemical vapour deposition (CVD).

Description of the Prior Art

As a thin film formation method there is known from EP-A-0104658 for example a photo CVD method which activates the reactive gases by optical energy. This method has the advantage that it enables film formation at low temperatures and does not damage the formed surface of the semiconductor substrate.

However, such known photo CVD method is aimed simply at carrying out film formation, with no attempts made to clean the semiconductor surface prior to the formation of the film.

There is also known a plasma CVD method which permits the formation of films with a thickness of from 500 nm to 1000 nm (5,000 Å to 1 micron) but such method is also known to damage the substrate in the course of film formation.

It has been proposed to generate active hydrogens by plasma discharge in a plasma CVD process and to utilize such active hydrogens for cleaning the semiconductor surface. However, these active hydrogens have large kinetic energy so that damage to the formed surface of the semiconductor substrate is inevitable when the semiconductor is a III-V group material, such III-V group materials being extremely soft and for this reason it is not possible to apply plasma cleaning methods to the III-V group compounds.

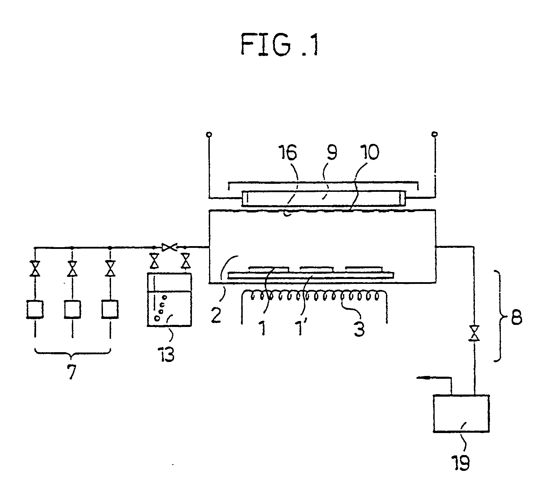

The photo CVD method of thin film deposition makes use of a substrate (1) held within a reaction chamber (2), heating means (3) for heating the substrate, and a low pressure mercury lamp (9) for irradiating the substrate, as shown by the example illustrated in Fig. 1 of the accompanying drawings. A doping system (7) is equipped with a mercury bubbler (13) for exciting the reactive gas, and an exhaust system (8) is equipped with a rotary pump (19). In forming amorphous silicon, for example, on the substrate (which is at a temperature of 250°C) as a reaction product, through introduction of a reaction gas, for instance disilane, from the doping system to the reaction chamber (2), there is also formed at the same time a thick silicon film on the mercury lamp covering plate (10) which is typically a quartz window for transmission of ultraviolet rays. To prevent the formation of a film on the window, an oil (for example a fluorine-based oil) (16) is commonly thinly coated on the window.

Now, while the use of the oil prevents the formation of a silicon film on the window (10), it causes oil components to become mixed in the film as impurities. Further, the tendency of the oil to be mixed in the film increases as the distance between the window and the surface of the formed film is reduced so that this distance cannot be made less than 4 cm (generally, it can be reduced only to 5 cm). On the other hand, however, a reduction of this distance is effective for increasing the irradiation by the ultraviolet rays from the mercury lamp of the semiconductor surface where the film is being formed.

## OBJECTS AND SUMMARY OF THE INVENTION

The object of the present invention is thus to provide a solution to the abovementioned problems.

According to the present invention there is provided a method of manufacturing a semiconductor device which includes the CVD formation of at least one thin film onto the surface of a III-V group compound semiconductor substrate characterized in that prior to the deposition of the thin film the semiconductor substrate surface is subjected to a cleaning step within the CVD apparatus for removal of surface contaminants, such cleaning step being effected by exposure of the substrate for a predetermined time period to active hydrogen and/or to an active halogen generated within the CVD apparatus by photodecomposition of a non-oxide hydride and/or halide introduced into the CVD apparatus.

In one of its aspects the invention provides for the generation of active hydrogens by photo-activating nonoxide hydrides such as ammonia or hydrazine (which are hydrogen nitrides) or methane, ethane, propane, or ethylene (which are hydrogen carbides). For example, in the known reactions :

$NH_3 + hv(193 \text{ nm}) \rightarrow NH_2 + H,$

$\rightarrow NH + 2H,$

H and 2H are active hydrogens. By virtue of the presence of these active hydrogens, oxides such as $Ga_2O_3$ and $As_2O_3$ that can contaminate the surface of a GaAs substrate as a result of the reaction of Ga and As with oxygen can be made to undergo reduction reactions as follows :

$$Ga_2O_3 + 6H \rightarrow 2Ga + 3H_2O,$$
$$As_2O_3 + 6H \rightarrow 2As + 6H_2O,$$

The reduced Ga and As can recombine with each other. Similarly, oxides on the surface of other III-V group compound semiconductor substrates can be removed.

Further, in carrying out the method of the present invention it is possible also to remove natural oxides that are formed spontaneously in III-V group semiconductors such as GaAs. In addition, the active hydrogen generated can neutralize Ga or As that exists locally in the semiconductor by joining with the dangling bonds of the Ga or As. Therefore, contamination of the semiconductor surface can be removed, and a nitride film, for example, silicon nitride or aluminum nitride, can be formed on the surface to a thickness of 1 to 5 nm (10 to 50 Å) by a vapor phase (active nitrogen, NH, $NH_2$, and others)-solid phase (GaAs, GaAlAs, and others) reaction. Since such a film possesses the capability of masking (blocking action) As which is easy to evaporate, dispersion of As into the outside can be obstructed. Further, the nitride film has sufficient blocking action against water, sodium, and others so that it has an advantage that it can prevent the formation of unstable compounds on the substrate surface.

More particularly, after the above photo-cleaning step, it is possible to form, in an ensuing photo CVD step using the same reaction furnace and without opening the furnace to the atmosphere, a nonoxide film on top of the substrate surface at a temperature below 250°C (between room temperature and 250°C, and preferably 100 to 200°C). At temperatures above 300°C, crystals of the III-V group compounds are damaged, and the internal junctions are rediffused. Because of this, formation of nonoxide films at temperatures below 250°C, preferably below 200°C, is extremely effective. As a result, the present invention has an advantage that during the formation of a film by the photo CVD method, there does not occur a drawback of generating changes in the crystal structure of the substrate itself.

In another of its aspects the invention provides for cleaning of the surface of a III-V group compound semiconductor by the generation of active fluorine or active chlorine by photo-activation of nonoxide halides such as $NF_3$ and $N_2F_4$ that are nitrogen fluorides, $NCl_3$ and $N_2Cl_4$ that are nitrogen chlorides, and $CF_3Br$, $H_2CF_2$, $HCCl_3$, and $H_2CCl_2$ that are carbide halides for example. At the same time, active hydrogens will also be generated in some cases. The active fluorine and hydrogen acts as explained hereinbefore to remove surface contaminants and has the same advantages as are mentioned hereinbefore.

Further, after the photo-cleaning process utilizing active halides, there can be formed by the photo CVD method a film that contains fluorine or chlorine, continuously using the identical reaction furnace without returning it to atmospheric pressure. Moreover, in case the thickness of the film formed by the photo CVD method was insufficient, a second film could be formed on top of it by the plasma CVD method in the same reaction furnace.

According to still another feature of the present invention, the distance between the window covering the ultraviolet source and the surface of the semiconductor substrate upon which the thin film was required to be formed was set to be 3 cm or less, and preferably 0.5 to 2 cm. By so doing, the speed of film formation was improved and the coating of the window with oil or the like, which was the source of impurities, was avoided.

Futher, the covering plate according to another feature of the present invention was advantageously constructed, instead of being a single quartz plate, as a louvre window consisting of a plurality of strips fixed to permit ventilation of the CVD reaction chamber. Such a louvre window is effective for admitting to the reaction chamber nonproduct gases (namely, gases which do not form solids by reaction or decomposition, such as He, Ar, $H_2$, $N_2$ $NH_3$, $N_2O$, $O_2$, and mixtures thereof) from the light source chamber through the openings between the louvres.

By virtue of this arrangement, the present invention provides a partial pressure reduction means which reduces the partial pressure of the reactive gases or active reaction products in the region of the transparent window so that the deposition of the reaction products on the transparent window is prevented or is made more difficult so as not to shut off the ultraviolet rays. This enables the distance between the surface of the semiconductor substrate and the transparent window to be reduced to less than 3 cm, preferably 0.5 to 2.0 cm.

According to the above feature of the present invention, it is possible to irradiate the substrate with high intensity ultraviolet rays of short wavelength of 185 nm, even without providing a coating of oil or the like on the window, so that the limiting thickness of the film that can be formed can be improved to 60 to 120 nm (600 to 1,200 Å). In other words, the necessary thickness for gate insulating films and passivation films becomes obtainable by means of the photo CVD method of the invention.

Further, the method of the present invention advantageously employs an oil-free system that does not use oil or the like on the window so that the background vacuum can be made below $133.3 \times 10^{-7} N/m^2$ ($10^{-7}$

Torr).

In this way, semiconductor films of silicon or the like, and conductor films of silicon oxide, silicon nitride, aluminum nitride and metals such as titanium and tungsten or their nitrides, can be formed by means of the photo CVD method.

Further features of the present invention are set forth in the appended claims and will be explained in the following description, given with reference to the accompanying drawings, of various exemplary embodiments of the invention.

## BRIEF DESCRIPTION OF THE DRAWINGS

Figure 1 shows a prior-art photo excitation CVD apparatus ;
Figure 2(A) and Fig. 2(B) show a semiconductor device which uses a III-V group compound ;
Figure 3 showns the photo-cleaning and photo CVD apparatus used in the method of the present invention;
Figure 4 shows another embodiment of the CVD apparatus used in the method of the present invention ;
Figure 5 shows the relation between film thickness and the distance between the window of the UV source and the surface on which the film is formed ; and
Figure 6 shows the C-V characteristic of a silicon nitride film formed by the present invention.

## DESCRIPTION OF THE PREFERRED EMBODIMENTS

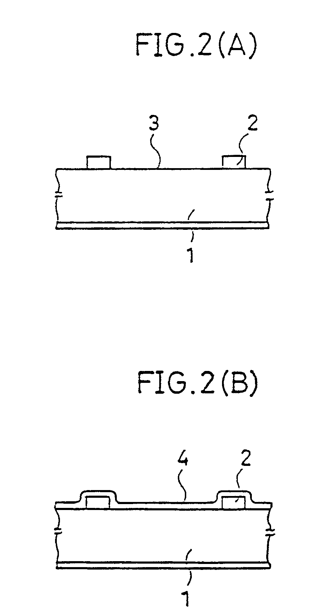

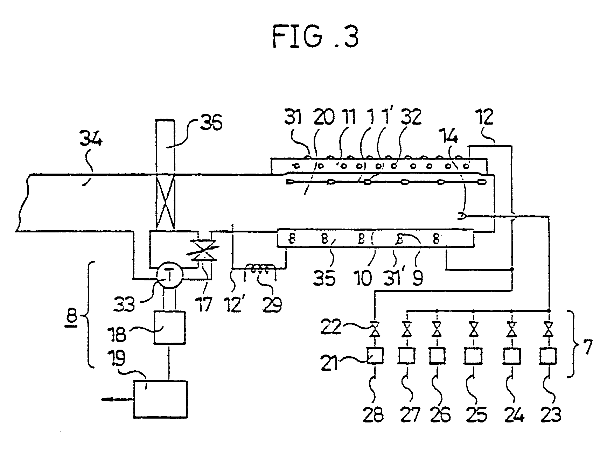

Referring to Fig. 2 and Fig. 3, the present invention will be described in the following.

In Fig. 2 is shown a GaAs single crystal semiconductor (1).

The surface of the semiconductor substrate (1) was cleaned for removal of contaminants (3) by the photo-cleaning and photo CVD apparatus shown in Fig. 3, and a nitride film (4) was formed on its top surface.

A brief outline of the photo-cleaning and photo CVD apparatus shown in Fig. 3 will be described in what follows. The substrate (1) is held by a holder (1') and is placed close to a halogen lamp heater (32) having its upper surface cooled with water (31) in a reaction chamber (20). The reaction chamber (20), a light source chamber (35) in which is provided an ultraviolet light source, and a heating chamber (11) in which is provided the heater (32) are arranged to hold their respective pressures that have approximately equal values of less than 1.3 KPa (10 torr). For that purpose, a gas (nitrogen, argon, or hydrogen) which does not affect the reaction was supplied to (12) from (28), and the gas was exhausted from (12'). The light source (35) and the reaction chamber (20) were partitioned by a synthetic quartz window (10). On the upper side of the window (10) there was provided a nozzle (14), and a mixed gas of ammonia ($NH_3$), nitrogen fluoride ($NF_3$), silane ($Si_nH_{2n+2}$, n $\geqq$ 2), and methyl aluminum ($Al(CH_3)_3$) was supplied to the reaction chamber.

In connection with the exhaust of the light source chamber, there was provided a heater (29) to prevent the mixing of the reactive gases in the light source chamber due to reverse current. With this arrangement, the component in the reactive gases that will become solids after decomposition was trapped to allow the reverse flow of gas component alone.

As regards transportation of the substrates, use was made of a load and lock system to avoid the creation of pressure difference. Namely, the substrate (1) and the holder (1') were inserted and arranged first in a preparation chamber (34), and after vacuum pumping, a gate valve (36) was opened to enable them to be transported to the reaction chamber (20). Then, the gate (36) was closed to partition the reaction chamber (20) from the preparation chamber (34). A doping system consists of a valve (22) and a flow meter (21), and reaction gases that will form solid products and gaseous products after reaction are supplied to the reaction chamber (20) from (23) and (24) and from (25) and (26), respectively. For photo-cleaning, ammonia or hydrazine was introduced from (25) and (26).

To carry out the photo CVD method, $Si_nH_{2n+2}$ (n $\geqq$ 2) was supplied in addition to the above materials. To control the pressure inside the reaction chamber, gas was exhausted by means of a turbo molecular pump (PG 550 made by Osaka Vacuum Co.,) (18) and a rotary pump (19) via a control valve (17).

In vacuum pumping the preparation chamber, a tap (33) of he exhaust system (8) was opened on the preparation chamber side and closed on the reaction chamber side. In addition, in vacuum pumping the reaction chamber, the reaction chamber side was opened and the preparation chamber side was closed.

In this way, the substrate was mounted in the reaction chamber as show. The vacuum of the reaction chamber was set to be below $133.3 \times 10^{-7} N/m^2$ ($10^{-7}$ Torr). After that, nitrogen was introduced from (28), and film formation was carried out by introducing reactive gases into the reaction chamber through (7).

As a light source for reaction use was made of low pressure mercury lamps (9) with water cooling (31'). The ultraviolet light source consisted of 16 low pressure mercury lamps made of synthetic quartz, each lamp having an illumination length of 40 cm and being able to radiate light of wavelengths 185 nm and 254 nm with a radiation intensity of 20 mw/cm² and lamp power of 40 W. The ultraviolet light irradiated the formed surface of the substrate (1) in the reaction chamber (20) via quartz window (10).

A "deposition up" system was adopted with the heater (32) provided on the top side of the reaction chamber and the UV source (35) irradiating the lower surface of the substrate (1), to avoid the possibility of pin holes being caused due to flakes falling from the heater (32) on to the surface of the substrate which is to be coated with a film.

The ultraviolet light source is housed within a stainless steel light source chamber coupled to the reaction chamber. The effective surface area over which thin films could be formed in the illustrated case was 30 cm × 30 cm, and a configuration was employed to permit the arrangement of four substrates (1) each with a diameter of 12.7cm (5 inches). The substrates could be heated to a predetermined temperature ranging from room temperature to 250°C.

Next, embodiments in accordance with the present invention will be described in Examples 1 and 4 to be given in the following.

Example 1... Example for forming silicon nitride film on GaAs film.

An N⁺PP⁺-type GaAs single crystal semiconductor was used as the substrate (1).

Namely, a P-type semiconductor was grown epitaxially to the thickness of about 5 microns on a P⁺-type GaAs substrate. Further, an N⁺ layer was grown epitaxially on top of it to a thickness of 100 to 200 nm (1000 to 2000 Å). Such a substrate is effective as a photoelectric converter. In addition, a gold film was formed on top of it by vacuum deposition to a thickness of 300 nm (3000 Å) to be used as an electrode (2), then, on the surface of the substrate there exist contaminants (3) such as oxides in the region outside of the electrode.

Then, the substrate were sealed in the reaction chamber, heated to 150°C, and ammonia was introduced from (25) at the flow rate of 300 cc/min. (pressure of 400 N/m² (3 Torr)). The ammonia releases active hydrogen (H) when it is decomposed by ultraviolet rays of 185 nm. Using this hydrogen (H), oxides on the surface of GaAs were cleaned and removed for about 30 minutes. The surface can also be nitrified to some extent to a thickness of 0.5 to 5 nm (5 to 50 Å) with the active nitrides (NH and NH₂) that are generated simultaneously.

Further, following the above process there were supplied into the same reaction chamber ammonia from (25) at 30 cc/mm, disilane from (23) at 8 cc/min, and nitrogen from (24) at 30 cc/min as reactive gases, and the substrates were heated to the temperature of 100°C. Substrates used were five wafers of diameter 5 cm (2 inches). The pressure within the reaction chamber (20) was set at 400 N/m² (3.0 Torr).

After a reaction for 50 minutes there was formed a silicon nitride film (4) with thickness 80 nm (800 Å). Thus, the speed of film formation was 1.7 nm/min (17 Å/min). The properties of the film obtained are as follows.

```
Area                       0.25   cm²

Open-circuit voltage       0.950  V

Release current            24.5   mA/cm²

Fill factor                0.74

Conversion efficiency      17.22  %
```

In the case of the plasma CVD method alone without applying the photo CVD method of the present invention, a conversion efficiency of only about 8% can be obtained. This shows that the conversion efficiency becomes far smaller than 13% for the case of forming absolutely no reflection checking film, which indicates clearly the effectiveness of forming a silicon nitride film on the surface of the GaAs compound semiconductor by the photo CVD method. Further, in the case of the so-called photo CVD alone without carrying out the photo-cleaning, there was obtained an efficiency of 15.2%, which showed that the generation of centers for carrier recombination on the surface can be prevented by the photo-cleaning.

Example 2... Example of forming aluminum nitride film.

Introducing ammonia in a manner similar to Example 1, photo-cleaning was carried out for 30 minutes at 200°C to remove oxides from the surface of GaAlAs. Following that, there were supplied methyl aluminum (Al(CH₃)₃) from (23) and hydrogen as carrier from (24), to the reaction system. In addition, ammonia was supplied from (27). With this, it was possible to form a film of thickness of 70 nm (700 Å) on the formed surface in a deposition time of 60 minutes.

In this case, the energy band of aluminum nitride (AlN) has a width of 6eV so that even if a film was formed on the window ((10) in Fig.3), it will not block ultraviolet rays and it was possible to form a film with the thickness that is necessary for a reflection checking film by the photo CVD method alone.

When AlN was formed, the conversion efficiency was 18.1% (AM 100 mW/cm$^2$) (open-circuit voltage of 0.91 V, release current of 23.0 mA/cm$^2$, and fill factor of 0.78), and characteristics nearly the same as those of silicon nitride were obtained.

In the method of the present invention as above described, use was made of ammonia as the nonoxide hydride. However, it may be substituted by hydrazine ($N_2H_4$), or mixed gas of $NH_3$ or $N_2H_4$ with hydrogen, helium, nitrogen, or argon. Further, in order to be able to generate active hydrogen, these nitrides may be replaced by hydrocarbons $C_2H_6$, $C_2H_4$, and others. In addition, use of gases of fluorides such as $NF_3$ and $N_2F_4$ or chlorides such as $NCl_3$ as the material for photo-cleaning is effective.

In the present invention, AlN obtained from $Al(CH_3)_3$ and $Si_3N_4$ obtained from $Si_2H_6$ and $NH_3$ were shown as nonoxide films. However, it is also possible to form similarly nonoxides such as GaN from $Ga(CH_3)_3$ and $NH_3$, GaP from $Ga(CH_3)_3$ and $PH_3$, and AlP from $Al(CH_3)_3$ and $PH_3$.

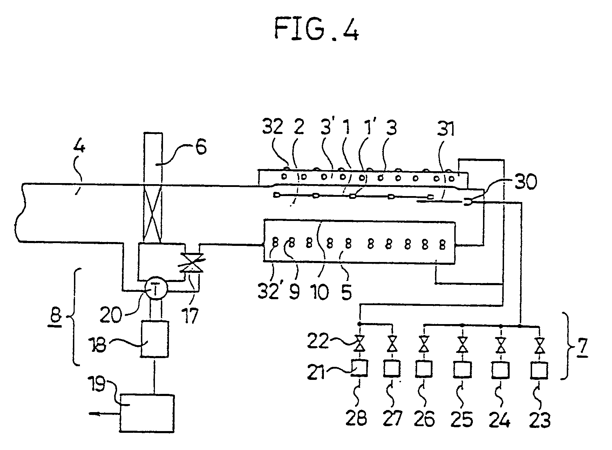

For the embodiments of Fig. 3 and Fig. 4, a photo-cleaning process which is different from that for the first and second embodiments was used. In that photo-cleaning process, there were introduced nitrogen fluoride from (25) and ammonia from (26). As a result, there were formed active fluorine, active hydrogen, and active nitrogen simultaneously and the surface of the semiconductor was cleaned by these.

Example 3... Example of forming silicon nitride film on GaAs substrate.

An N$^+$PP$^+$-type GaAs single crystal semiconductor described in the foregoing was used as substrate (1).

Namely, a P-type semiconductor was grown epitaxially on a P$^+$-type GaAs substrate to a thickness of about 5 microns. On tope of it an N$^+$ layer was further grown epitaxially to a thickness of 100 to 200 nm (1000 to 2000 Å). This substrate is effective as a photoelectrical converter. Further, gold was formed on top of it to the thickness of 300 nm (3000 Å) by vacuum evaporation method to use it as the electrode (2). Then, there exists contaminants (3) such as oxides in the region of the semiconductor other than that of the electrode.

After that, the substrate was sealed in the reaction chamber, heated to 150°C, and nitrogen fluoride was introduced from (25) at 30 cc/min (pressure of 400 N/m$^2$ (3 Torr)). In addition, ammonia was introduced from (26) at 30 cc/min. Then, nitrogen fluoride and ammonia release active fluorine (F) and active hydrogen (H) that are decomposed by ultraviolet rays of 185 nm. Oxides on the surface of GaAs were cleaned by (F) and (H) for about 30 minutes to be removed. The active nitrides (NF, $NH_2$, NH, and $NH_2$) that are generated at the same time can nitrify the surface to some extent to a thickness of 0.5 to 5 nm (5 to 50 Å).

Further, after the above process, nitrogen fluoride was introduced from (25) at 30 cc/min, ammonia from (26) at 30 cc/min, disilane from (23) at 8 cc/min, and nitrogen from (24) at 30 cc/min as reactive gases into the same reaction region, and the substrate temperature was raised to 100°C. The number of substrates placed in the reaction chamber was five wafers of diameter of 5 cm (2 inches). The pressure within the reaction chamber (20) was set to 400 N/m$^2$ (3.0 Torr).

After a reaction of 50 minutes, a silicon nitride film (4) of thickness 75 nm (750 Å) that contains fluorine at less than 1 atomic %, for example, about 0.1 atomic %, was formed. The speed of film formation was 1.6 nm/min (16 Å/min). The properties of the film obtained were as follows.

| | | |
|---|---|---|
| Area | 0.25 | cm$^2$ |
| Open-circuit voltage | 0.940 | V |
| Release current | 25.6 | mA/cm$^2$ |
| Fill factor | 0.78 | |
| Conversion efficiency | 18.76 | % |

If the plasma CVD method alone is applied without applying the photo CVD method of the present invention, the conversion efficiency obtained can be only about 8%. This value is far smaller than 13% of the conversion efficiency for the case of not forming at all a reflection checking film. Therefore, the usefulness of forming a silicon nitride film on the surface of the GaAs compound semiconductor by the photo CVD method became clear. Further, in the so-called photo CVD alone, without applying the photo-cleaning, the efficiency of 15.2% was obtained. Therefore, it was found by this that the generation of the recombination centers on the surface can be prevented by the photo-cleaning.

Example 4... Example of forming silicon oxide film.

Similar to Example 3, $H_2CF_2$ was introduced to the reaction chamber at the flow rate of 30 cc/min, and photo-cleaning was carried out at 300°C for 30 minutes by further introducing hydrogen (30 cc/min) as carrier gas, to remove oxides on the surface of the semiconductor. In addition after this, $N_2O$ and $SiH_4$ were supplied from (23) and (24), respectively, and nitrogen as carrier gas was introduced from (27), to this reaction system. In this way, it was possible to form by deposition for 60 minutes a film of thickness 70 nm (700 Å) on the formed surface. It was found from the infrared spectrum of the film that it contained SiF in an amount which is less than 1 atomic %. That is, fluorides were found to be mixed in the film. This suggests the possibility of these compounds acting as sufficient blocking agents for contamination such as sodium and others in the later processes.

If $H_2SiCl_2$ is used as a reaction gas, chlorine can be contained in the film at the same time. Namely, atoms of halogens can be mixed simultaneously in the film, sodium ions in the film can be neutralized, and form clean oxides at low temperatures below 350°C.

In this case, the energy band of silicon oxide ($SiO_2$) has a width of 8ev. Therefore, even if a film is formed on the window ((10) in Fig. 3), it will not block ultraviolet rays so that it is possible to form a film which has a necessary thickness as a reflection checking film can be formed by the photo CVD method alone.

Here, by mixing $PH_3$ or $B_2H_6$ at the time, it is possible to obtain phosphorus glass or bromine glass.

When AIN was formed, there was obtained a conversion efficiency of 18.1% (AM 100 mW/cm²) (open-circuit voltage of 0.91 V, release current of 23.0 mA/cm², and fill factor of 0.78), with characteristics that are nearly the same as those of silicon nitride.

In the third and fourth examples, use was made of $NH_3$, $Si_2F_6$, $H_2SiCl_2$, and others as the gases of nonoxides. However, mixed gases of these gases with hydrogen, helium, nitrogen, or argon may also be used

In the present invention, films of $SiO_2$ obtained from $SiH_4$ and $N_2O$ and $Si_3N_4$ obtained from $Si_2H_6$ and $NH_3$ were shown. However, it is possible to prepare nitride or oxides to which are added halogens also by the photo CVD method such as AIN from $Al(CH_3)_3$ and $NH_3$, GaN from $Ga(CH_3)_3$ and $NH_3$, GaP from $Ga(CH_3)_3$ and $PH_3$, AIP from $Al(CH_3)_3$ and $PH_3$, $Si_3N_4$ from $Si_2F_6$ and $NH_3$, $Si_3N_4$ from $SiH_4$ and $NH_3$, $SiO_2$ from $SiF_4$ and $O_2$, $SiO_2$ from $Si_2F_6$ and $O_2$, $SiO_2$ from $SiH_4$ and NO or $NO_2$, those compounds that are mixed with phosphorous and bromine.

As may be clear from the description in the foregoing, the present invention makes it possible to accomplish the formation of films of arbitrary thickness on a substrate of large area using the same reaction chamber, without damaging the formed surface. In addition, reproducibility from one batch to the next can be improved by the photo-cleaning of the surface of semiconductor elements. Regarding photo-cleaning, removal of oxides and dirt may be done not only by use of active hydrogen or by active fluorine or chlorine but also by mixing active hydrogen and fluorine or chlorine at the same time. By forming a film on the cleaned semiconductor by the photo CVD method, possibility of recontamination of the surface of the semiconductors was avoided. With the present invention there can be formed semiconductor devices such as photoelectric converter, MES FET (field effect semiconductor devices), SL elements (super-lattice elements), and HEMT elements. In addition, the present invention is also effective for semiconductor lasers, or optical integrated circuits (using III-V group compounds such as GaAs). Needless to say, as the light source use may be made of excimer laser (wavelength from 100 to 400 nm), argon laser, nitrogen laser, and the like, instead of or simultaneously with a low voltage mercury lamp. The present invention, is similarly effective for semiconductors of III-V compounds such as GaAlAs, InP, and GaN not only for GaAs.

Next, a fifth embodiment of the present invention will be described.

In Fig. 4, a substrate (1) that has a formed surface held by a holder (1') is placed close to a halogen heater (3) (its upper surface being water cooled (32)) above a reaction chamber (2). The reaction chamber (2), a light source chamber (5) provided with a source of ultraviolet rays (9), and a heating chamber (3') provided with the heater (3) are maintained at an approximately equal vacuum of a pressure less than $133.3 \times 10^{-5}$ N/m² (100 Torr). For this purpose, nonproduct gases (nitrogen, hydrogen, helium, or argon) that do not affect, and do not participate in, the reaction are supplied to the light source chamber (5) and a heating chamber (3') through (27) via a flow meter (21) and a valve (22).

In the present embodiment, among the reactive gases, product gases (gases that form solids after reaction) are introduced (31) from (23), and oxide gases ($O_2$, $N_2O$, NO, and $NO_2$) or nitride gases ($NH_3$, $N_2H_4$, $NF_3$, and

$N_2F_4$) that are nonproduct gases that participate in the reaction are introduced from (26), into the reaction space by a nozzle (30).

For example, in preparing a semiconductor such as silicon as the reaction product, use was made of silane ($Si_nH_{2n+2}$ n $\geqq 1$) and silicon fluorides ($SiF_2$, $SiF_4$, $Si_2F_6$, and $H_2SiF_2$) that are gases of silicides as the product gases. Further, as carrier gases of nonproduct gases use was made of hydrogen, nitrogen, argon, or helium which was supplied from (24).

In preparing nitrides (silicon nitrides, aluminum nitride, gallium nitride, indium nitride, and antimony nitride) as the reaction product, use was made of $Si_2H_6$, $Al(H_3)_3$, $Ga(CH_3)_3$, $In(CH_3)_3$, $Sn(CH_3)_4$, and $Sb(CH_3)_3$ which were supplied from (23). In addition, as nonproduct gases use was made of ammonia or hydrazine which was supplied from (26). Further, nonproduct gas (hydrogen or helium) that does not particiate in the reaction was supplied from (24) and (28) as a carrier gas.

In preparing oxides (silicion oxide, phosphorus glass, boron glass, aluminum oxide, indium oxide, tin oxide, antimony oxide, or mixture of these) as the reaction product, use was made of oxides ($N_2O$, $O_2$, $NO$, or $NO_2$) as nonproduct gases which was supplied from (26). In this case, use was made of compound of silicon ($SiH_4$, $Si_2H_6$, and $Si_2F_6$), compounds of aluminum ($Al(CH_3)_3$), compounds of indium ($In(CH_3)_3$ and $InCl_3$), compounds of tin ($SnCl_4$ and $Sn(CH_3)_4$), and compounds of antimony ($Sb(CH_3)_3$ and $SbCl_3$) that were supplied from (23). As nonproduct gases that participate in the reaction, in addition, hydrogen or helium as nonproduct gas that does not participate in the reaction was supplied from (24) as the carrier gas. Further, phosphine ($PH_3$) and diborane ($B_2H_6$) were supplied from (25).

In preparing conductors (aluminum, tungsten, molybdenum, titanium, or their silicides), hydrogen, argon, or helium was used as a nonproduct gas. As the product gases, $Al(CH_3)_3$, $WF_6$, $MoCl_5$, and $TiCl_4$ or their mixtures with $SiH_4$, $SiF_2$, $SiH_2Cl_2$, and $SiF_4$ were supplied from (23) and (24). Hydrogen as nonproduct gas that does not participate in the reaction was supplied from (27) and (25) as the carrier gas.

The pressure control of the reaction chamber was accomplished by exhausting from a turbo molecular pump (18) (used PG550 made by Osaka Vacuum Co.) and a rotary pump through a control valve (17) and a cock (20).

The exhaust system (8) opened a preparation chamber (4) and closed the reaction chamber (2) side by means of the cock (20), for vacuum pumping the preparation chamber (4). In addition, to vacuum pump the reaction chamber or carry out photo chemical reaction, the reaction chamber side was opened and the preparation chamber side was closed.

The formation process of films employed the load and lock system so as not to create pressure difference in moving the substrate from the preparation chamber to the reaction chamber. First, substrate (1) and holder (1') were inserted and arranged in the preparation chamber. After vacuum pumping the preparation chamber, a gate valve (6) between the reaction chamber which was vacuum pumped in advance to $133.3 \times 10^{-7} N/m^2$ ($10^{-7}$ Torr) or below, was opened to move the substrates (1) and the holder (1') to the reaction chamber (2), and the gate valve (6) was closed to partition the reaction chamber (2) and the preparation chamber (4).

Later, in order to prevent mixing of the reactive gases into the light source by the reverse, nonproduct gases were introduced first to the light source chamber and the heating chamber at the flow rate of 100 to 1,500 cc/min, and at the same time a nonproduct gas, for example, $NH_3$, was supplied to the reaction chamber in a similar manner. It was left standing in this state for about 30 minutes, and photo-cleaning of the formed surface of the substrate was carried out by generating active hydrogen and fluorine by the photo-decomposition of the gases. Later, the product gases among the reactive gases were supplied through a nozzle (30).

As the light source for reaction use was made of a low voltage mercury lamp (9) made of synthetic quartz tube with water cooling (32). The source of the ultraviolet rays consisted of 16 low voltage mercury lamps (with illumination length of 40 cm, irradiation intensity of 20 mw/cm², and lamp power of 45 W that can radiate light with 185 nm and 254 nm) made of synthetic quartz.

The ultraviolet rays irradiate, through transparent covering plate (10) made of synthetic quartz, reactive gases (31) and the formed surface of the substrates (1) in the reaction space of the reaction chamber (2). For the heater (3), a deposition up system was employed by placing it on the upper side of the reaction chamber (2) to avoid the creation of a cause for pin holes due to attachment of flakes on the formed surface. In addition, the substrates (1) were heated from the rear side by a halogen lamp heater to a predetermined temperature (between the room temperature and 700°C).

The reaction chamber was made of stainless steel, and the source of the ultraviolet rays was placed in the light source chamber which was kept under vacuum. The light source chamber and the reaction chamber were held under pressure-reduced atmosphere enclosed in a stainless steel container. Because of this, it was possible to form a film on a substrate with size of 30 cm × 30 cm, not a small film formation area of 5 cm × 5 cm, without any particular engineering problems.

Further, a complete example of the above invention will be described in the following.

Example 5... Example of forming silicon nitride film.

In Fig. 4, ammonia was supplied from (25) as a reactive gas at 50 cc/min and disilane was supplied from (23) at 20 cc/min as a reactive gas, and the substrate temperature was set to 300°C (33), 200°C (34), and 100°C (35) see, Fig. (5). The substrate had four wafers of diameter 12.7 cm (5 inches). The pressure within the reaction chamber (2) was set at 400 N/m² (3.0 Torr).

Nitrogen as a nonproduct gas that does not participate in the reaction was introduced from (26) at 200 cc/min and ammonia as a nonproduct gas that could participate in the reaction was introduced from (27) at 200 cc/min.

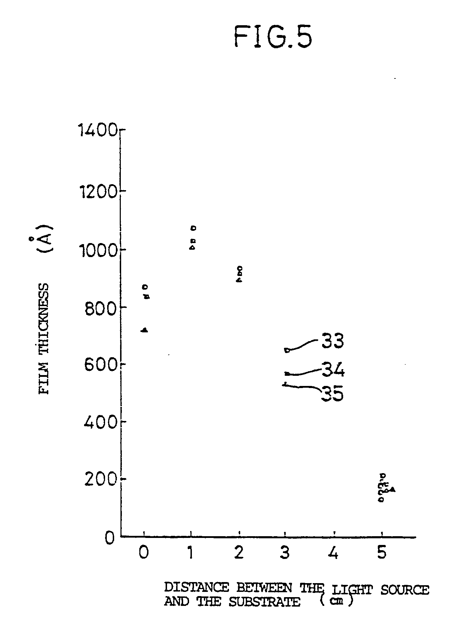

The dependence of the thickness of silicon nitride in the range of 20 to 110 nm (200 to 1,100 Å) formed by the reaction for 50 minutes, on the distance, given as abscissa, between the covering plate and the substrate with a film surface, is shown in Fig.5. It will be seen from Fig. 5 that the maximum film thickness of 100 nm (1,000 Å) was obtained for the distance of 1 cm. Also, it became clear that it is extremely important that the distance has to be less than 3 cm in order to obtain a film thickness greater than 50 nm (500 Å).

From the figure, it can be seen that the film thickness does not depend too much on the temperature. On the contrary, however, it depends strongly on the intensity of light. Based on this, it is conjectured that the film thickness will become large correspondingly when the light intensity becomes greater than 20 mW/cm².

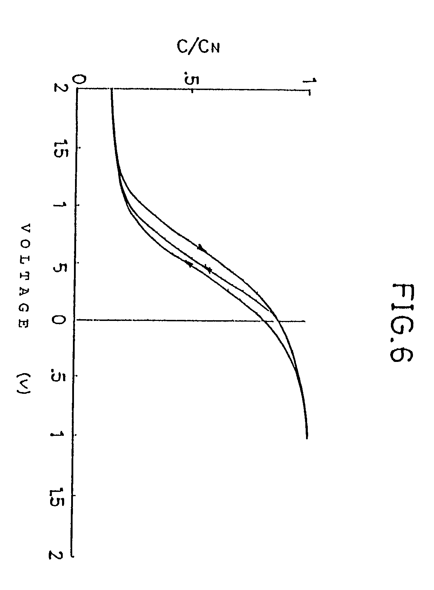

In Fig. 6 is shown the C-V characteristic of silicon nitride film formed on silicon semiconductor, for the case of the distance of 2 cm and the substrate temperature of 300°C.

The graph corresponds to the case of frequency of 1 MHz, temperature of 300°C, silicon nitride film thickness of 35.2 nm (352 Å), CN of 3786 pF, and impurity concentration of $4 \times 10^{15}$ cm⁻³. As a result, it was possible to obtain a flat band voltage of $-0.39$ V and a surface level density Qss/q of $8.6 \times 10^{10}$ cm⁻². It is extremely worthwhile to note that a surface level density of less than $1 \times 10^{11}$ cm⁻² was obtained by CVD method.

As is clear from the above description, according to the fifth embodiment, it was possible, in forming a film on a substrate of large area, to obtain, in addition to the effects of the previous embodiments, a maximum film thickness by setting the distance between the transparent covering plate and the formed surface to be 3 cm or less, preferably 0.5 to 2.0 cm. In addition, by increasing the irradiation intensity in the present invention, it was possible to increase the film thickness, and to obtain an extremely excellent film of silicon nitride with surface level density of less than $1 \times 10^{11}$ cm⁻². Further, in the present invention, a louvre window comprising a plurality of window elements instead of a simple synthetic quartz window, may be used, and in addition, it is possible also to provide a partial pressure reduction means on the reaction chamber side. In that case, it is necessary to keep the smallest separation between the upper end portion of the partial pressure reduction means and the formed surface to be 3 cm or less.

In the present invention, there is absolutely no need for coating oil on the upper surface of the window. Consequently impurities such as carbon has difficulty to infiltrate into the film and the exhaust pressure can be made to a high vacuum of $133.3 \times 10^{-7}$ N/m² ($10^{-7}$ Torr), so that it is possible to prepare oil-free films of high purity.

In the present invention, the film growth speed may be improved by letting gases pass through a mercury bubbler.

In Fig. 3, the light source was arranged in the lower part and the reaction space was provided in the upper part. However, if it is possible to prevent the generation of flakes by arranging the reaction space in the lower part, contrary to the above, a corresponding arrangement of the substrate is possible and also easy. Moreover, the light source may be arranged sideways.

## Claims

1. A method of manufacturing a semiconductor device which includes the CVD formation of at least one thin film onto the surface of a III-V group compound semiconductor substrate characterized in that prior to the deposition of the thin film the semiconductor substrate surface is subjected to a cleaning step within the CVD apparatus for removal of surface contaminants, such cleaning step being effected by exposure of the substrate for a predetermined time period to active hydrogen and/or to an active halogen generated within the CVD apparatus by photodecomposition of a non-oxide hydride and/or halide introduced into the CVD apparatus.

2. A method as claimed in claim 1 wherein said predetermined time period is about 30 minutes.

3. A method as claimed in claim 1 or 2 wherein the non-oxide hydride comprises ammonia or hydrazine and/or wherein the non-oxide halide comprises a nitrogen compound such as $NF_3$, $N_2F_4$, $NCl_3$, $N_2Cl_4$ for example.

4. A method as claimed in any preceding claim wherein the thin film that is deposited on the semiconductor substrate is a nitride film and the cleaning step is effected by use of nitrogen hydride and/or halide so as to give rise to a degree of nitridation of the substrate surface during the cleaning step.

5. A method as claimed in any preceding claim wherein the thin film is deposited at a temperature no greater than 250°C.

6. A method as claimed in any preceding claim wherein the CVD. formation of the at least one thin film is effected by photodecomposition of CVD constituents.

7. A method as claimed in claim 6 wherein a CVD apparatus is utilized for the cleaning and thin film deposition steps which comprises a reaction chamber (2), a substrate holder (1') in the reaction chamber, and a light source (9) associated with the reaction chamber for effecting photodecomposition of cleaning and CVD constituents introduced into the reaction chamber, the light source being arranged to illuminate the reaction chamber through a transparent window (10) and the substrate holder (1') being spaced from such window by such a distance that in the performance of the thin film deposition step the substrate surface to be coated by the thin film is spaced less than 3 cm from the window surface.

8. A method as claimed in any of claims 1 to 6 wherein a CVD apparatus is utilized for the cleaning and thin film deposition steps which comprises a reaction chamber (2), a substrate holder (1') in the reaction chamber, a gas supply system for the introduction of gaseous cleaning and CVD constituents into the reaction chamber, and a light source (9) associated with the reaction chamber (2) for effecting photodecomposition of cleaning and CVD constituents in the reaction chamber, the light source (9) being contained within a chamber (5) coupled to the reaction chamber and being arranged to illuminate the reaction chamber through a transparent louvre window.

9. A method as claimed in claim 8 wherein non-product gases involved in the performance of the method and which do not form solids by reaction or decomposition are introduced into the reaction chamber by way of the light source chamber (5) and the louvre window.

10. A method as claimed in claim 8 or 9 wherein in the performance of the thin film deposition step the substrate surface to be coated by the thin film is spaced less than 3 cm from the closest part of the louvre window.

## Ansprüche

1. Verfahren zur Herstellung einer Halbleitervorrichtung, umfassend die CVD-Ausbildung mindestens einer Dünnschicht auf der Oberfläche eines Halbleitersubstrats aus einer Verbindung von Elementen der Gruppen III-V, dadurch gekennzeichnet, daß vor dem Auftragen der Dünnschicht die Oberfläche des Halbleitersubstrats einem Reinigungsschritt in dem CVD-Apparat unterworfen wird, um Oberflächen-Verunreinigungen zu entfernen, wobei dieser Reinigungsschritt dadurch bewirkt wird, daß das Substrat eine vorgegebene Zeitspanne lang aktivem Wasserstoff und/oder einem aktiven Halogen ausgesetzt wird, das in dem CVD-Apparat durch Photozersetzung eines in den CVD-Apparat eingeleiteten sauerstoff-freien Hydrids und/oder Halogenids erzeugt wird.

2. Verfahren nach Anspruch 1, wobei die vorgegebene Zeitspanne etwa 30 min beträgt.

3. Verfahren nach Anspruch 1 oder 2, wobei das sauerstofffreie Hydrid Ammoniak oder Hydrazin umfaßt und/oder wobei das sauerstoff-freie Halogenid eine Stickstoffverbindung wie beispielsweise $NF_3$, $N_2F_4$, $NCl_3$, $N_2Cl_4$ umfaßt.

4. Verfahren nach einem der vorhergehenden Ansprüche, wobei die auf dem Halbleitersubstrat aufgetragene Dünnschicht ein Nitridfilm ist und der Reinigungsschritt unter Verwendung eines Stickstoffwasserstoffs und/oder -halogenids ausgeführt wird, so daß die Substratoberfläche während des Reinigungsschritts bis zu einem gewissen Grad nitriert wird.

5. Verfahren nach einem der vorhergehenden Ansprüche, wobei die Dünnschicht bei einer Temperatur nicht über 250°C aufgetragen wird.

6. Verfahren nach einem der vorhergehenden Ansprüche, wobei die CVD-Ausbildung mindestens einer Dünnschicht durch Photozersetzung von CVD-Bestandteilen bewirkt wird.

7. Verfahren nach Anspruch 6, wobei für die Schritte der Reinigung und des Dünnschicht-Auftrags ein CVD-Apparat verwendet wird, der eine Reaktionskammer (2), einen in dieser vorhandenen Substrathalter (1') und eine der Reaktionskammer zugeordnete Lichtquelle (9) zur Photozersetzung von in die Reaktionskammer eingeleiteten Reinigungs- und CVD-Bestandteilen umfaßt, wobei die Lichtquelle so angeordnet ist, daß sie die Reaktionskammer durch ein transparentes Fenster (10) hindurch beleuchtet und der Substrathalter (1') in einem derartigen Abstand von dem Fenster angeordnet ist, daß bei der Ausführung des Dünnschicht-Auftragsschrittes die mit der Dünnschicht zu beschichtende Substratoberfläche sich in einem Abstand von weniger als 3 cm von der Oberfläche des Fensters befindet.

8. Verfahren nach einem der Ansprüche 1 bis 6, wobei für die Schritte der Reinigung und des Dünnschicht-Auftrags ein CVDApparat verwendet wird, der eine Reaktionskammer (2), einen in dieser vorhandenen Substrathalter (1'), ein Gaszuführsystem zum Einleiten gasförmiger Reinigungs- und CVD-Bestandteile in die Reaktionskammer und eine der Reaktionskammer (2) zugeordnete Lichtquelle (9) zur Photozersetzung der Reinigungs- und CVD-Bestandteile in der Reaktionskammer umfaßt, und wobei die in einer Kammer (5) enthaltene Lichtquelle (9) mit der Reaktionskammer gekoppelt und so angeordnet ist, daß sie die Reaktionskammer durch ein transparentes Rasterfenster hindurch beleuchtet.

9. Verfahren nach Anspruch 8, wobei nicht-reaktive Gase, die an der Durchführung des Verfahrens teilnehmen und keine Feststoffe durch Reaktion oder Zersetzung bilden, über die Lichtquellenkammer (5) und das Rasterfenster in die Reaktionskammer eingeleitet werden.

10. Verfahren nach Anspruch 8 oder 9, wobei bei Ausführung des Dünnschicht-Auftragsschrittes die mit der Dünnschicht zu beschichtende Substratoberfläche sich in einem Abstand von weniger als 3 cm vom nächsten Teil des Rasterfensters befindet.

## Revendications

1. Procédé de fabrication d'un dispositif à semi-conducteurs, qui comprend la formation, par procédé CVD, d'au moins un film mince sur la surface d'un substrat semi-conducteur de composé des groupes III-V, caractérisé par le fait qu'avant le dépôt du film mince, on soumet la surface du substrat semi-conducteur à une étape de nettoyage, à l'intérieur de l'appareil CVD, pour l'élimination des contaminants de surface, une telle étape de nettoyage étant effectuée par exposition du substrat, pendant une période de temps prédéterminée, à de l'hydrogène actif et/ou à un halogène actif produit à l'intérieur de l'appareil CVD par photodécomposition d'un hydrure et/ou halogénure non-oxyde introduit dans l'appareil CVD.

2. Procédé selon la revendication 1, dans lequel ladite période de temps prédéterminée est d'environ 30 minutes.

3. Procédé selon la revendication 1 ou 2, dans lequel l'hydrure non-oxyde comprend l'ammoniac ou l'hydrazine et/ou dans lequel l'halogénure non-oxyde comprend un composé de l'azote, tel que $NF_3$, $N_2F_4$, $NCl_3$, $N_2Cl_4$ par exemple.

4. Procédé selon l'une des revendications précédentes, dans lequel le film mince qui est déposé sur le substrat semi-conducteur est un film de nitrure, et l'étape de nettoyage est effectuée à l'aide d'hydrure et/ou halogénure d'azote, de façon à donner naissance à un degré de nitruration de la surface du substrat pendant l'étape de nettoyage.

5. Procédé selon l'une des revendications précédentes, dans lequel le film mince est déposé à une température non supérieure à 250°C.

6. Procédé selon l'une des revendications précédentes, dans lequel la formation par le procédé CVD du (ou des) film(s) mince(s) est effectuée par photodécomposition de constituants CVD.

7. Procédé selon la revendication 6, dans lequel un appareil CVD est utilisé pour les étapes de nettoyage et de dépôt du (ou des) film(s) mince(s), qui comprend une chambre de réaction (2), un support de substrat (1') dans la chambre de réaction, et une source de lumière (9) associée à la chambre de réaction pour effectuer la photodécomposition des constituants de nettoyage et CVD introduits dans la chambre de réaction, la source de lumière étant disposée pour éclairer la chambre de réaction à travers une fenêtre transparente (10), et le support de substrat (1') étant éloigné d'une telle fenêtre d'une distance telle que, dans la réalisation de l'étape de dépôt du (ou des) film(s) mince(s), la surface de substrat devant être revêtue par le film mince soit éloignée de moins de 3 cm de la surface de la fenêtre.

8. Procédé selon l'une des revendications 1 à 6, dans lequel un appareil CVD est utilisé pour les étapes de nettoyage et de dépôt du (ou des) film(s) mince(s), qui comprend une chambre de réaction (2), un support de substrat (1') dans la chambre de réaction, un système d'alimentation de gaz pour l'introduction de constituants gazeux de nettoyage et CVD dans la chambre de réaction, et une source de lumière (9) associée à la chambre de réaction (2), pour effectuer la photodécomposition des constituants de nettoyage et CVD dans la chambre de réaction, la source de lumière (9) étant contenue à l'intérieur d'une chambre (5) couplée à la chambre de réaction et étant disposée pour éclairer la chambre de réaction à travers une fenêtre transparente du type jalousie.

9. Procédé selon la revendication 8, dans lequel des gaz non-produits mis en jeu dans la réalisation du procédé et qui ne forment pas de solides par réaction ou décomposition sont introduits dans la chambre de réaction par la chambre (5) contenant la source de lumière et de la fenêtre du type jalousie.

10. Procédé selon la revendication 8 ou 9, dans lequel, dans la réalisation de l'étape de dépôt du (ou des) film(s) mince(s), la surface de substrat devant être revêtue par le film mince est éloignée de moins de 3 cm de la partie la plus proche de la fenêtre du type jalousie.

# FIG .1

# FIG.2(A)

# FIG.2(B)

# FIG .3

FIG.4

FIG.5

FIG.6